# EUROPEAN PATENT APPLICATION

(11) **EP 2 007 183 A2**
(43) Date of publication of application: **24.12.2008**
(21) Application number: 08157019.4
(22) Date of filing: 27.05.2008
(51) Int. Cl.: H05K 7/20

(54) **Cooling structure for inverter housing**

(30) Priority: 19.06.2007 JP 2007160941
(71) Applicant: FANUC LTD, Minamitsuru-gun, Yamanashi 401-0597 (JP)
(72) Inventor: Yamada, Yuuichi, Yamanashi 401-0597 (JP); Takeshita, Makoto, Yamanashi 401-0597 (JP); Yamamoto, Kazuhiro, Yamanashi 401-0597 (JP)
(74) Representative: Ward, James Norman

(57) **Abstract**

In a cabinet (1), an inverter housing (2) is mounted on an inverter housing mounting surface (5). Heat-exchanger-side pipe connection ports (3) are disposed so as to extend through the inverter housing mounting surface toward a heat exchanger for use as an air-cooling device. Further, controller-mounting-side pipe connection ports (6) are disposed so as to extend on a controller mounting side (7). A refrigerant supply line (8) is a refrigerant passage through which a refrigerant is cyclically fed from the refrigerant cooling device. One end of the refrigerant supply line is connected to the heat-exchanger-side pipe connection ports or the controller-mounting-side pipe connection ports, while the other end is connected to the refrigerant cooling device that penetrates an appropriate part of a wall of the cabinet and is situated in a proper position outside the cabinet.

## Description

### BACKGROUND OF THE INVENTION

### Field of the invention

The present invention relates to a piping structure for a refrigerant for cooling a heat sink of an inverter with use of the refrigerant and a cabinet structure for the inverter.

### Description of the Related Art

It is a known technique to cool a heat sink of an inverter mounted in a controller with a coolant. According to Japanese Patent Application Laid-Open No. 8-90252, an external pipe connection port of a cooling section is set on the front surface of a power source unit, thereby solving problems including difficulties in piping work and maintenance and inspection operation caused when the external pipe connection port of the cooling section is set on the rear surface of the power source unit.

If piping for the coolant for cooling the heat sink of the inverter is installed on the controller side, the coolant sometimes may leak out through the connection port, possibly adversely affecting the controller. If the piping is installed on a heat exchanger side (i.e., the side where the heat sink (heat exchanger) for cooling power elements and resistors is located) opposite from a mounting surface for an inverter housing, the heat exchanger is situated behind a cabinet, so that the piping is installed in close contact with a wall or the like. If a sufficient space structurally cannot be secured for piping installation or maintenance, therefore, it is difficult to install the piping on the heat exchanger side.

Since the cabinet is miniaturized, moreover, the inverter housing itself is also expected to be miniaturized. Accordingly, it is a difficult task to secure the piping space and arrange the piping.

### SUMMARY OF THE INVENTION

Accordingly, in order to solve the above problems, the object of the present invention is to provide a cabinet configured so that an optimum cooling pipe arrangement can be selected depending on a panel installer's circumstances and the pipe setting operation can be performed with ease.

A piping structure according to the present invention is disposed on a cabinet and serves to circulate a refrigerant used to cool a heat sink of an inverter. The piping structure comprises: pipe connection ports disposed individually so as to extend on a controller mounting side of the cabinet and on a heat exchanger side opposite the controller mounting side; and a pipe for the refrigerant, selectively connected to either the pipe connection port disposed on the controller mounting side or the pipe connection port disposed on the heat exchanger side.

The pipe connection port disposed on the controller mounting side and the pipe connection port disposed on the heat exchanger side may be formed on the heat sink itself.

The pipe connection port disposed on the controller mounting side and the pipe connection ports disposed on the heat exchanger side may be provided on a pipe connection port setting part independent of the heat sink, and the pipe connection port setting part has a pipe connection port connected to the heat sink and is connected to the heat sink.

A structure of a cabinet according to the present invention has a piping structure for circulating a refrigerant used to cool a heat sink of an inverter. The piping structure comprises: pipe connection ports disposed individually so as to extend on a controller mounting side of the cabinet and a heat exchanger side opposite the controller mounting side; and a pipe for the refrigerant, selectively connected to either the pipe connection port disposed on the controller mounting side or the pipe connection port disposed on the heat exchanger side. And the cabinet has an inverter housing mounting surface provided with a panel cut which allows the pipe disposed on the heat exchanger side to be connected from the controller mounting side, the panel cut being configured to be closed after the pipe connection.

With the piping structure of the present invention, a cooling pipe arrangement can be selected from both the controller mounting side and the heat exchanger side of the cabinet, depending on a panel installer's circumstances, and the cabinet can be installed easily. By the use of the pipe connection port setting part, moreover, the heat sink can be reduced in thickness and hence in size. Since the position of the pipe connection port of the port setting part can be designed with a predetermined degree of freedom, the easiness of piping work is improved. Furthermore, the piping work and maintenance and inspection operation can be performed with ease when the pipe connection port that extends on the heat exchanger side is selected.

### BRIEF DESCRIPTION OF THE DRAWINGS

The above and other objects and features of the present invention will be obvious from the ensuing description of embodiments with reference to the accompanying drawings, in which:
FIG. 1A is a schematic view of a cabinet on which a piping structure for circulating a refrigerant used to cool a heat sink of an inverter is set, the piping structure having its pipe connection ports arranged individually on a controller mounting side and a heat exchanger side, and shows a state in which a refrigerant supply line is connected to a controller-mounting-side pipe connection port;
FIG. 1B shows a state in which the refrigerant supply line shown in FIG. 1A is connected to a heat-exchanger-side pipe connection port;
FIG. 2A is a side view of a first example of an inverter housing in the piping structure shown in FIGS. 1A and 1B;
FIG. 2B is a perspective view of the inverter housing shown in FIG. 2A;
FIG. 3A is a side view of a second example of the inverter housing in the piping structure shown in FIGS. 1A and 1B, in which a pipe connection port setting part is connected to the heat sink;
FIG. 3B is a perspective view of the inverter housing and the pipe connection port setting part shown in FIG. 3A; and
FIG. 4 is a perspective view showing a modification of the cabinet shown in FIGS. 1A and 1B.

### DETAILED DESCRIPTION OF THE PREFERRED EMBODIMENTS

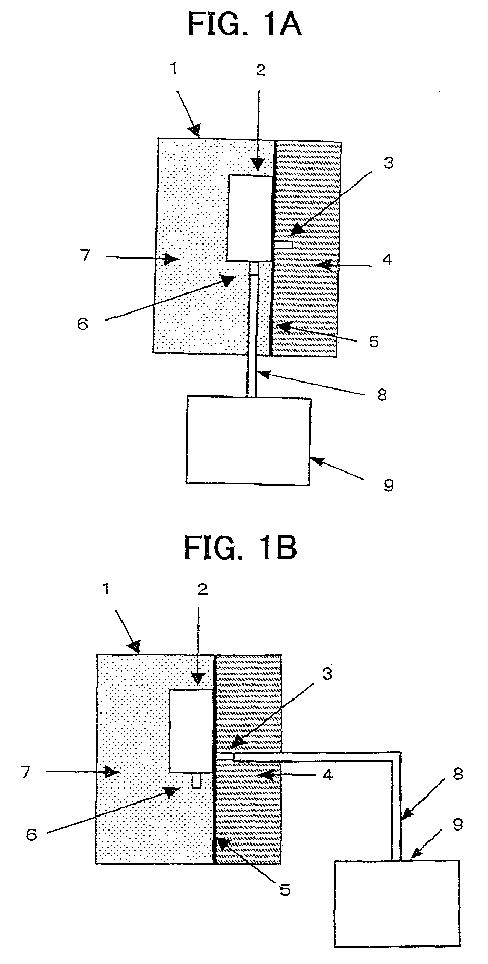

FIGS. 1A and 1B are schematic views of a cabinet on which a piping structure for circulating a refrigerant used to cool a heat sink 10 of an inverter is set. The piping structure has its pipe connection ports arranged individually on a controller mounting side and a heat exchanger side.

In a cabinet 1, an inverter housing 2 is mounted on an inverter housing mounting surface 5. If necessary, a plurality of inverter housings (not shown in FIGS. 1A and 1B) may be arranged in the cabinet 1. Heat-exchanger-side pipe connection ports 3 are disposed so as to extend through the inverter housing mounting surface 5, on a controller mounting side 7 where the inverter housing 2 is mounted (or on the side opposite from the side (heat exchanger side 4) where the heat sink (heat exchanger) for cooling power elements and resistors is located). Further, controller-mounting-side pipe connection ports 6 are disposed so as to extend on the controller mounting side 7.

A refrigerant supply line 8 through which the refrigerant supplied from the refrigerant cooling device 9 is circulated has one end connected to one of the heat-exchanger-side pipe connection ports 3 or the controller-mounting-side pipe connection ports 6 and the other end connected to the cooling device 9. The refrigerant cooling device 9 penetrates an appropriate part of a wall of the cabinet 1 and is situated in a proper position outside the cabinet 1. The refrigerant that is cyclically fed from the cooling device 9 may suitably be a gas such as nitrogen gas, a liquid such as water or oil, or a solid-liquid slurry based on water and ice.

FIG. 1A shows a state in which the refrigerant supply line 8 is connected to the controller-mounting-side pipe connection port 6, and FIG. 1B shows a state in which the line 8 is connected to the heat-exchanger-side pipe connection port 3.

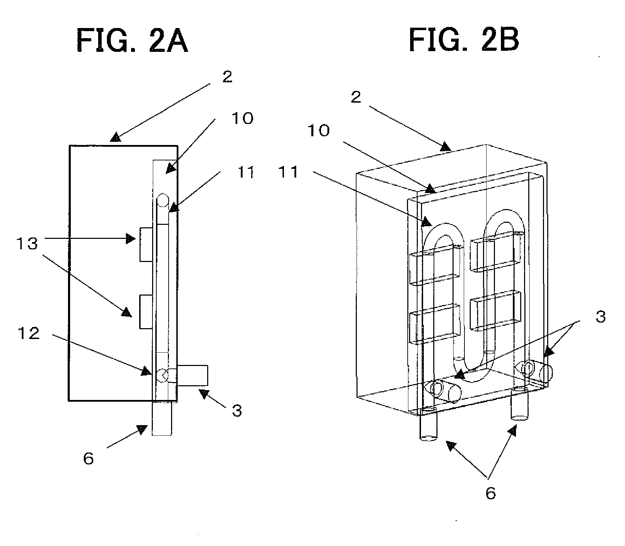

FIGS. 2A and 2B show an example in which branching points 12 from which passages diverge are formed at parts of the heat sink 10. FIGS. 2A and 2B show the way the heat sink 10 itself is formed with the pipe connection ports 3 and 6 on the heat-exchanger and controller-mounting sides, respectively, of the cabinet. The passage branching points 12 from which the heat-exchanger-side pipe connection ports 3 and the controller-mounting-side pipe connection ports 6 diverge are formed inside the heat sink 10.

The refrigerant that is cyclically fed through the heat-exchanger-side pipe connection ports 3 or the controller-mounting-side pipe connection ports 6 cools the heat sink 10 that is disposed in the inverter housing 2. Heat from heating parts 13 is released through the heat sink 10. The heat sink 10 is formed by joining, for example, two aluminum plates together. A groove is formed in at least one of the aluminum plates so as to define a passage for the refrigerant. If the two aluminum plates are joined together so that the groove in the one aluminum plate faces the other aluminum plate, the refrigerant passage is formed in the heat sink 10. Alternatively, the refrigerant passage may be formed by laying a pipe of a different material with high thermal conductivity, such as a copper pipe, along the groove. Alternatively, moreover, the heat sink 10 may be formed of one aluminum plate such that a groove is formed in one side surface of the aluminum plate and that the refrigerant passage is formed by laying the pipe of the different material along the groove.

As shown in FIG. 2B, the refrigerant passage is constructed so as to extend in zigzag in a heat sink section and cool the entire heat sink 10. Since the passage branching points 12 are thus formed inside the heat sink 10, they require no dedicated installation spaces.

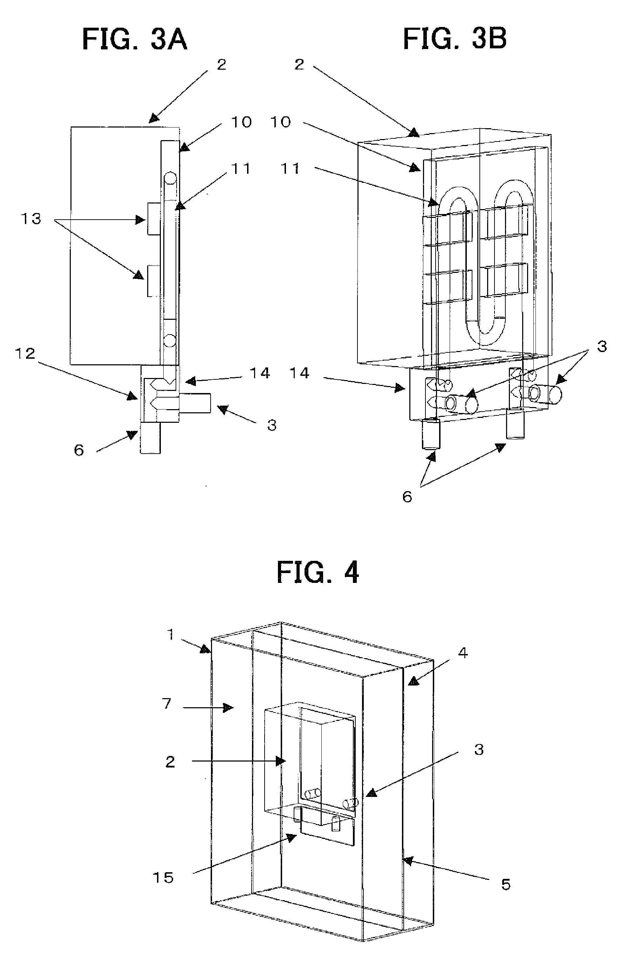

FIGS. 3A and 3B show an example in which a pipe connection port setting part 14 is connected to the heat sink 10 so as to form branch passages. In this example, compared with the example in which the passage branching points 12 are formed inside the heat sink 10, as shown in FIGS. 2A and 2B, the heat sink 10 itself has so simple a construction that it can be reduced in thickness.

The pipe connection port setting part 14 includes pipe connection ports connected to the heat sink 10, heat-exchanger-side pipe connection ports 3, and controller-mounting-side pipe connection ports 6. Since the pipe connection port setting part 14 is independent of the heat sink 10, the respective positions of the pipe connection ports can be suitably adjusted by changing the shape of the part 14 as required.

FIG. 4 is a perspective view showing a cabinet structure using a form of pipe connection. The inverter housing mounting surface 5 of the cabinet 1 is provided with a panel cut 15, which serves as an operation opening for pipe connection disposed on the heat exchanger side 4 from the controller mounting side 7. When the pipe connection is completed, the heat exchanger side 4 and the controller mounting side 7 can be separated by closing the panel cut 15 lest heat or oil mist be transferred from the heat exchanger side 4 to the controller mounting side 7.

## Claims

1. A piping structure which is disposed on a cabinet and serves to circulate a refrigerant used to cool a heat sink of an inverter, the piping structure comprising:
pipe connection ports disposed individually so as to extend on a controller mounting side of the cabinet and on a heat exchanger side opposite the controller mounting side; and
a pipe for the refrigerant, selectively connected to either the pipe connection port disposed on the controller mounting side or the pipe connection port disposed on the heat exchanger side.

2. The piping structure according to claim 1, wherein the pipe connection port disposed on the controller mounting side and the pipe connection port disposed on the heat exchanger side are formed on the heat sink itself.

3. The piping structure according to claim 2, wherein a passage branching point from which the pipe connection port disposed on the controller mounting side and the pipe connection port disposed on the heat exchanger side diverge is formed inside the heat sink.

4. The piping structure according to claim 1, wherein the pipe connection port disposed on the controller mounting side and the pipe connection ports disposed on the heat exchanger side are provided on a pipe connection port setting part independent of the heat sink, and the pipe connection port setting part has a pipe connection port connected to the heat sink and is connected to the heat sink.

5. The piping structure according to claim 4, wherein a passage branching point from which the pipe connection ports disposed on the controller mounting side and the pipe connection port disposed on the heat exchanger side diverge is formed inside the pipe connection port setting part.

6. A structure of a cabinet in which a piping structure for circulating a refrigerant used to cool a heat sink of an inverter is disposed, the piping structure comprising:
pipe connection ports disposed individually so as to extend on a controller mounting side of the cabinet and a heat exchanger side opposite the controller mounting side; and
a pipe for the refrigerant, selectively connected to either the pipe connection port disposed on the controller mounting side or the pipe connection port disposed on the heat exchanger side,
the cabinet having an inverter housing mounting surface provided with a panel cut which allows the pipe disposed on the heat exchanger side to be connected from the controller mounting side, the panel cut being configured to be closed after the pipe connection.
